# EUROPÄISCHE PATENTSCHRIFT

(11) **EP 1 227 500 B1**
(45) Veröffentlichungstag und Bekanntmachung des Hinweises auf die Patenterteilung: **14.12.2005**
(21) Anmeldenummer: 02000600.3
(22) Anmeldetag: 10.01.2002
(51) Int. Cl.: G11C 16/28

(54) **Schaltung zur Feststellung des Ladezustands nichtflüchtiger Halbleiterspeicherzellen**
Circuit for determining the charge state of nonvolatile memory cells
Circuit de détection de l'état de charge des cellules de mémoire nonvolatiles

(30) Priorität: 18.01.2001 DE 10102180
(43) Veröffentlichungstag der Anmeldung: 31.07.2002
(73) Patentinhaber: Infineon Technologies AG, 81669 München (DE)
(72) Erfinder: Schienle, Meinrad, 85579 Deutschland (DE)
(74) Vertreter: Graf Lambsdorff, Matthias

(56) Entgegenhaltungen:
- EP-A- 0 809 256
- US-A- 5 528 543
- US-A- 6 128 228
- PATENT ABSTRACTS OF JAPAN vol. 1999, no. 12, 29. Oktober 1999 (1999-10-29) & JP 11 203882 A (DENSO CORP), 30. Juli 1999 (1999-07-30)
- PATENT ABSTRACTS OF JAPAN vol. 1998, no. 02, 30. Januar 1998 (1998-01-30) & JP 09 259592 A (NISSAN MOTOR CO LTD), 3. Oktober 1997 (1997-10-03)

## Beschreibung

Die Erfindung bezieht sich generell auf das Gebiet der Halbleiterspeicher. Insbesondere betrifft die Erfindung eine Schaltung zum Auslesen eines Stroms aus einer nichtflüchtigen Speicherzelle, aus welchem der Ladezustand der Speicherzelle ermittelt werden kann.

Das Grundelement einer nichtflüchtigen Speicherzelle ist ein MOS-Transistor mit einem zusätzlichen Floating-Gate. Das Floating-Gate ist eine allseitig durch Siliziumoxid isolierte Gateelektrode. Es befindet sich zwischen dem Steuergate und der Source-Drain-Strecke und besitzt keinen Anschluß. Auf das Floating-Gate können durch Tunneleffekte Ladungsträger aufgebracht werden. Die dort befindlichen Ladungsträger lassen sich wegen der hervorragenden Isolatoreigenschaften des Siliziumoxids über Jahre speichern und ermöglichen eine nichtflüchtige Informationsspeicherung. Derartige nichtflüchtige Speicherzellen finden insbesondere Verwendung bei Halbleiterspeicherbausteinen wie EEPROMs (Electrically Erasable Programmable Read Only Memory), EAROMs (Electrically Alterable Read Only Memory) oder Flash-EPROMs (Erasable Programmable Read Only Memory).

Ladungsträger, die sich auf dem Floating-Gate einer Speicherzelle befinden, verändern die Strom-Spannungs-Charakteristik der Speicherzelle. Je nach Art der aufgebrachten Ladungsträger und nach Typ des MOS-Transistors wird die Schwellenspannung des MOS-Transistors erhöht oder erniedrigt. Zum Auslesen des Ladezustands der Speicherzelle werden an das Steuergate und an den Drainanschluß vorgegebene Spannungen angelegt. Der Sourceanschluß ist in der Regel mit einer gemeinsamen Masse verbunden. Liegen an der Speicherzelle geeignete Spannungen an, so hängt das Vorhandensein eines Stromflusses zwischen Source und Drain von dem Ladezustand der Speicherzelle ab. Das Auftreten eines Stromflusses am Drainanschluß zeigt folglich den Ladezustand der Speicherzelle an. Der Strom wird am Drainanschluß der Speicherzelle durch eine sogenannte Bitleitung ausgelesen. Zur Feststellung des Ladezustands der Speicherzelle wird der durch die Bitleitung ausgelesene Strom mit einem Referenzwert verglichen. Meistens wird als Referenz ein Strom aus einer Referenzzelle mit bekanntem Ladezustand herangezogen.

Ein fehlerfreies Auslesen des Ladezustands der Speicherzelle setzt eine stabile und gegenüber Störimpulsen unempfindliche Spannung am Drainanschluß, welche im folgenden als Bitleitungsspannung bezeichnet wird, voraus. Des weiteren muß die Bitleitungsspannung in einem bestimmten Spannungsbereich liegen. Zum einen muß die Bitleitungsspannung für den Betrieb der Speicherzelle ausreichend hoch sein. Zum anderen darf die Bitleitungsspannung einen bestimmten Höchstwert nicht überschreiten, da sonst der Ladezustand der Speicherzelle beim Auslesen verändert werden könnte. Darüber hinaus ist für ein schnelles Auslesen des Ladezustands der Speicherzelle die Geschwindigkeit entscheidend, mit welcher eine entladene Bitleitung auf die vorgegebene Bitleitungsspannung aufgeladen werden kann.

Bisherige Schaltungen zum Auslesen eines dem Ladezustand einer Speicherzelle entsprechenden Stroms, wie sie z.B. in den Schriften US 5 528 543 A und EP 0 936 620 A1 beschrieben sind, verwenden häufig einen MOS-Transistor, dessen Source-Drain-Strecke die Bitleitung speist. Die Gateelektrode des MOS-Transistors wird von dem Ausgang eines Inverters angesteuert, wobei der Eingang des Inverters mit der Bitleitung verbunden ist. Daraus ergibt sich ein Regelkreis für die Bitleitungsspannung. Der Sollwert für die Bitleitungsspannung ist durch die Dimensionierung der Transistoren im Inverter bestimmt. Nachteilig an derartigen Ausleseschaltungen ist, daß der Sollwert der Bitleitungsspannung im Inverter von der Versorgungsspannung abgeleitet wird. Dadurch ergibt sich eine schlechte Störunterdrückung der Bitleitungsspannung gegenüber Schwankungen der Versorgungsspannung. Des weiteren läßt sich der Sollwert der Bitleitungsspannung im Inverter nur ungenau und nicht temperaturunabhängig einstellen.

Ferner sind in der europäischen Offenlegungsschrift EP 0 809 256 A2, den U.S.-Patentschriften US 6,128,228 und US 5,528,543 sowie der japanischen Veröffentlichung JP 11 203882 weitere Ausleseschaltungen für Speicherzellen beschrieben. Die in diesen Schriften erwähnten Ausleseschaltungen weisen den Nachteil auf, dass zu ihrem Betrieb jeweils eine relativ hohe Versorgungsspannung erforderlich ist. Die Spannungsabfälle an den Bauelementen, die zwischen die Versorgungsspannung und die Bitleitung geschaltet sind, erfordern nämlich eine genügend hohe Versorgungsspannung, um trotz der Spannungsabfälle eine für den Betrieb der Speicherzelle ausreichend hohe Spannung zur Verfügung zu stellen.

Der Erfindung liegt daher die Aufgabe zugrunde, eine Ausleseschaltung zur Feststellung des Ladezustands einer nichtflüchtigen Speicherzelle zu schaffen, die bei kleinen Versorgungsspannungen betrieben werden kann.

Die der Erfindung zugrundeliegende Aufgabenstellung wird durch die Merkmale des unabhängigen Patentanspruchs gelöst. Vorteilhafte Weiterbildungen und Ausgestaltungen sind in den Unteransprüchen angegeben.

Bei der erfindungsgemäßen Ausleseschaltung zur Feststellung des Ladezustands einer nichtflüchtigen Speicherzelle entspricht der Ladezustandsstrom der Speicherzelle ihrem Ladezustand. Zum Auslesen des Ladezustandsstroms ist an einen Leseausgang der Speicherzelle, durch welchen der Ladezustandsstrom fließt, ein erster Anschluß der Source-Drain-Strecke eines Regeltransistors geschaltet. An den zweiten Anschluß der Source-Drain-Strecke des Regeltransistors ist eine Versorgungsspannung angelegt. Der Ausgang eines Differenzverstärkers ist mit dem Gateanschluß des Regeltransistors verbunden. An den ersten Eingang des Differenzverstärkers ist eine vorgegebene Spannung angelegt. Der zweite Eingang des Differenzverstärkers ist mit dem Leseausgang verbunden. Die Ausleseschaltung weist ferner einen Komparator auf, dessen erster Eingang mit dem Ausgang des Differenzverstärkers verbunden ist. An dem zweiten Eingang des Komparators liegt ein vorgegebener Referenzwert an. Aus dem Ausgangssignal des Komparators kann der Ladezustand der Speicherzelle ermittelt werden.

Bei der erfindungsgemäßen Ausleseschaltung wird das Ausgangssignal des Differenzverstärkers herangezogen, um den Ladezustand der Speicherzelle festzustellen. Das Ausgangssignal kann entweder der Ausgangsstrom oder die Ausgangsspannung des Differenzverstärkers sein. Die erfindungsgemäße Ausleseschaltung weist zwei wesentliche Vorteile auf. Zum einen entfällt bei der erfindungsgemäßen Ausleseschaltung mindestens ein zusätzlicher Transistor für eine separate Stromspiegelschaltung. Die Funktion des Stromspiegeltransistors übernimmt der Regeltransistor. Dieses verringert den Spannungsabfall zwischen der Versorgungsspannung und der Bitleitung. Daher ist die erfindungsgemäße Ausleseschaltung auch bei einer kleinen Versorgungsspannung einsetzbar. Zum anderen kann die Bitleitung bei der erfindungsgemäßen Ausleseschaltung auch bei einer kleinen Versorgungsspannung in minimaler Zeit geladen werden, da der Regeltransistor von dem Differenzverstärker bei großen Regelabweichungen voll aufgesteuert wird.

Bei der erfindungsgemäßen Ausleseschaltung wird die an dem Leseausgang anliegende vorgegebene Spannung, welche identisch mit der Bitleitungsspannung ist, nicht notwendigerweise von der Versorgungsspannung abgeleitet, sondern die vorgegebene Spannung kann beispielsweise von einem externen, störunanfälligen Schaltkreis erzeugt werden und über den aus dem Differenzverstärker und dem Regeltransistor bestehenden Regelkreis an den Leseausgang angelegt werden. Eine Schwankung der Versorgungsspannung führt daher nicht zu einer Änderung des Sollwerts der Bitleitungsspannung. Die Möglichkeit, die vorgegebene Spannung bei der erfindungsgemäßen Ausleseschaltung extern erzeugen zu können, hat des weiteren zum Vorteil, daß dadurch im Vergleich mit einer Inverterschaltung eine wesentlich genauere Einstellung des Sollwerts der vorgegebenen Spannung möglich ist. Eine Schaltung zur Spannungserzeugung, die den soeben aufgeführten Anforderungen genügt, ist beispielsweise eine Bandabstandsreferenz-Schaltung.

Die erfindungsgemäße Ausleseschaltung kombiniert die oben genannten Vorteile gegenüber herkömmlichen, dem gleichen Zweck dienenden Ausleseschaltungen mit einer hohen Auslesegeschwindigkeit. Der Grund dafür ist, daß das Aufladen der Bitleitung durch den aktiven Regelkreis relativ schnell erfolgt.

In vorteilhafter Weise wird für den Regeltransistor ein p-Kanal-MOSFET eingesetzt, dessen Drainanschluß an dem Leseausgang anliegt. Simulationen der erfindungsgemäßen Schaltung ergaben, daß die Verwendung eines p-Kanal-MOSFETs die Störfestigkeit der Schaltung gegen Schwankungen der Versorgungsspannung (PSRR, Power Supply Rejection Rate) erhöht. Insbesondere gilt dieses für die hochfrequenten Anteile der Schwankungen. Hochfrequente Schwankungen können von einem Regelverstärker selbst nicht ausgeregelt werden, da der Regelverstärker hierzu grundsätzlich zu langsam ist. Hochfrequente Schwankungen der Versorgungsspannung entstehen in Digitalschaltungen bei jedem Schaltvorgang und sind damit unvermeidbar.

Eine weitere vorteilhafte Ausgestaltung der Erfindung ist dadurch gekennzeichnet, daß die vorgegebene Spannung durch eine Bandabstandsreferenz-Schaltung erzeugt wird. Das Grundprinzip einer Bandabstandsreferenz-Schaltung besteht darin, zwei Teilsignale (Spannungen oder Ströme), die ein gegenläufiges Temperaturverhalten aufweisen, zu addieren. Während eines der beiden Teilsignale mit zunehmender Temperatur fällt, steigt das andere Teilsignal mit zunehmender Temperatur an. Aus der Summe der beiden Teilsignale wird eine über einen gewissen Temperaturbereich temperaturunabhängige Ausgangsspannung abgeleitet. Diese Spannung ist wesentlich genauer einstellbar sowie störunanfälliger gegenüber Schwankungen der Temperatur und der Versorgungsspannung als eine durch eine Inverterschaltung erzeugte Spannung.

Gemäß einer vorteilhaften Ausgestaltung der Ausleseschaltung wird der vorgegebene Referenzwert über eine Referenzzelle mit einem vorgegebenen Ladezustand bezogen. Dazu wird die Referenzzelle an eine Schaltung angeschlossen, die der Beschaltung der Speicherzelle entspricht und das dem Ladezustand der Referenzzelle entsprechende Signal ermittelt. Der Ausgang des Differenzverstärkers dieser Schaltung ist mit dem zweiten Eingang des Komparators verbunden. Da der Ladezustand der Referenzzelle bekannt ist, kann aus dem Vergleich der von der Speicherzelle und der Referenzzelle erzeugten Signale auf den Ladezustand der Speicherzelle geschlossen werden. Um den Vergleich der beiden Signale möglichst einfach zu gestalten, wird vorteilhafterweise an die Leseausgänge der Speicher- und der Referenzelle die gleiche Spannung angelegt.

Des weiteren kann vorgesehen sein, daß die Speicherzelle in einer matrixförmigen Anordnung aus nichtflüchtigen Speicherzellen enthalten ist. Durch Schaltmittel kann die Speicherzelle aus der Anordnung ausgewählt und mit der Ausleseschaltung verbunden werden. Dieses erschließt die Möglichkeit, die Ladezustände mehrerer Speicherzellen mit nur einer Ausleseschaltung zu bestimmen.

Die erfindungsgemäße Ausleseschaltung kann beispielsweise in nichtflüchtigen Halbleiterspeicherbausteinen, wie z.B. in EEPROM-, EAROM- oder Flash-EPROM-Speicherbausteinen, eingesetzt werden.

Die Erfindung wird nachfolgend in beispielhafter Weise unter Bezugnahme auf die Zeichnungen erläutert. Diese zeigen:
- Fig. 1: eine Ausleseschaltung zur Feststellung des Ladezustands einer nichtflüchtigen Speicherzelle aus dem Stand der Technik;
- Fig. 2: eine weitere Ausleseschaltung zur Feststellung des Ladezustands einer nichtflüchtigen Speicherzelle;
- Fig. 3: eine Schaltung zum Auslesen eines Ladezustandsstroms aus einer nichtflüchtigen Speicherzelle;
- Fig. 4: ein erstes Ausführungsbeispiel der erfindungsgemäßen Ausleseschaltung zur Feststellung des Ladezustands einer nichtflüchtigen Speicherzelle; und
- Fig. 5: ein zweites Ausführungsbeispiel der erfindungsgemäßen Ausleseschaltung zur Feststellung des Ladezustands einer nichtflüchtigen Speicherzelle.

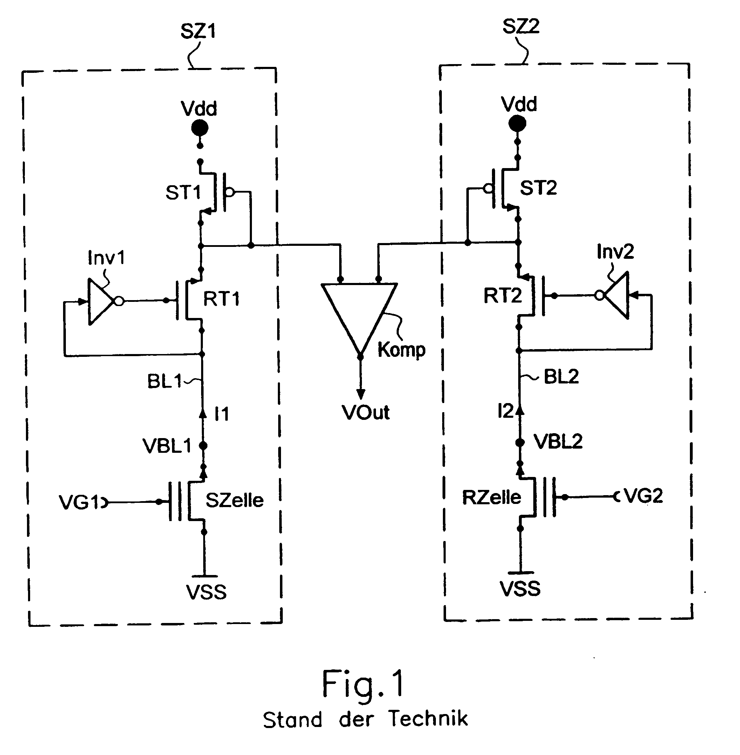

In Fig. 1 ist eine Ausleseschaltung zur Feststellung des Ladezustands einer nichtflüchtigen Speicherzelle dargestellt, wie sie im Stand der Technik häufig Verwendung findet. Ein erster Eingang eines Komparators Komp ist mit einem Schaltungszweig SZ1 verbunden, ein zweiter Eingang des Komparators Komp ist an einen Schaltungszweig SZ2 gekoppelt. Der Schaltungszweig SZ1 weist eine nichtflüchtige Speicherzelle SZelle auf. Der Drainanschluß der Speicherzelle SZelle ist mit einem Ende einer Bitleitung BL1 verbunden. Der Sourceanschluß der Speicherzelle SZelle liegt auf einem gemeinsamen festen Potential, insbesondere einer Masse VSS. Das andere Ende der Bitleitung BL1 steht mit dem Drainanschluß eines Regeltransistors RT1 in Verbindung. Des weiteren ist der Drainanschluß des Regeltransistors RT1 mit dem Eingang eines Inverters Inv1 verbunden. Der Ausgang des Inverters Inv1 speist die Gateelektrode des Regeltransistors RT1. Der Sourceanschluß des Regeltransistors RT1 ist an den Drainanschluß eines Stromspiegeltransistors ST1 gekoppelt. Der Sourceanschluß des Stromspiegeltransistors ST1 liegt an einer Versorgungsspannung VDD. Der Drain- und der Gateanschluß des Stromspiegeltransistors ST1 sind miteinander verbunden und speisen den ersten Eingang des Komparators Komp. Der Regeltransistor RT1 ist ein n-Kanal-MOSFET, der Stromspiegeltransistor ST1 ein p-Kanal-MOSFET.

Der Inverter Inv1 und der Regeltransistor RT1 stellen einen Regelkreis dar. Dabei steuert der Inverter Inv1 die Gateelektrode des Regeltransistors RT1 derart, daß die an der Bitleitung BL1 anliegende Bitleitungsspannung VBL1 einen vorgegebenen Wert annimmt. Der Sollwert der Bitleitungsspannung VBL1 ergibt sich aus den Dimensionierungen der in dem Inverter Inv1 enthaltenen Transistoren. Sofern an der Bitleitung BL1 eine geeignete Bitleitungsspannung VBL1 und an dem Gate der Speicherzelle SZelle eine geeignete Gatespannung VG1 anliegt, ermöglicht oder verhindert die auf dem Floating-Gate der Speicherzelle SZelle befindliche Ladung das Fließen eines Stroms I1 durch die Bitleitung BL1. Falls ein Strom I1 durch den Schaltungszweig SZ1 fließt, verursacht der Stromspiegeltransistor ST1 im Komparator Komp das Fließen eines Stroms, dessen Größe linear von der Größe des Stroms I1 abhängt.

Der Schaltungszweig SZ2 ist in analoger Weise zu dem Schaltungszweig SZ1 aufgebaut. Dazu weist der Schaltungszweig SZ2 als Bauelemente eine Bitleitung BL2 mit einer Bitleitungsspannung VBL2, einen n-Kanal-MOSFET als Regeltransistor RT2, einen Inverter Inv2 und einen p-Kanal-MOSFET als Stromspiegeltransistor ST2 auf. Anstatt einer Speicherzelle enthält der Schaltungszweig SZ2 eine Referenzzelle RZelle, deren Ladezustand vorgegeben ist. Der Ausgang des Schaltungszweigs SZ2 speist den zweiten Eingang des Komparators Komp.

Im Schaltungszweig SZ2 generiert der aus dem Regeltransistor RT2 und dem Inverter Inv2 bestehende Regelkreis eine Bitleitungsspannung VBL2 an der Bitleitung BL2. Dadurch wird in Abhängigkeit von dem vorgegebenen Ladezustand der Referenzzelle RZelle und von der Gatespannung VG2 der Referenzzelle RZelle ein Strom I2 in dem Schaltungszweig SZ2 erzeugt. Der Stromspiegeltransistor ST2 veranlaßt im Komparator Komp den Fluß eines Spiegelstroms zu dem Strom I2.

Der Komparator Komp vergleicht die Größen der in ihm erzeugten Spiegelströme, welche in linearer Weise von den Größen der Ströme I1 und I2 abhängen, und gibt ein dementsprechendes Ausgangssignal VOut aus. Da der Ladezustand der Referenzzelle RZelle bekannt ist, läßt sich aus dem Ausgangssignal VOut auf den Ladezustand der Speicherzelle SZelle schließen.

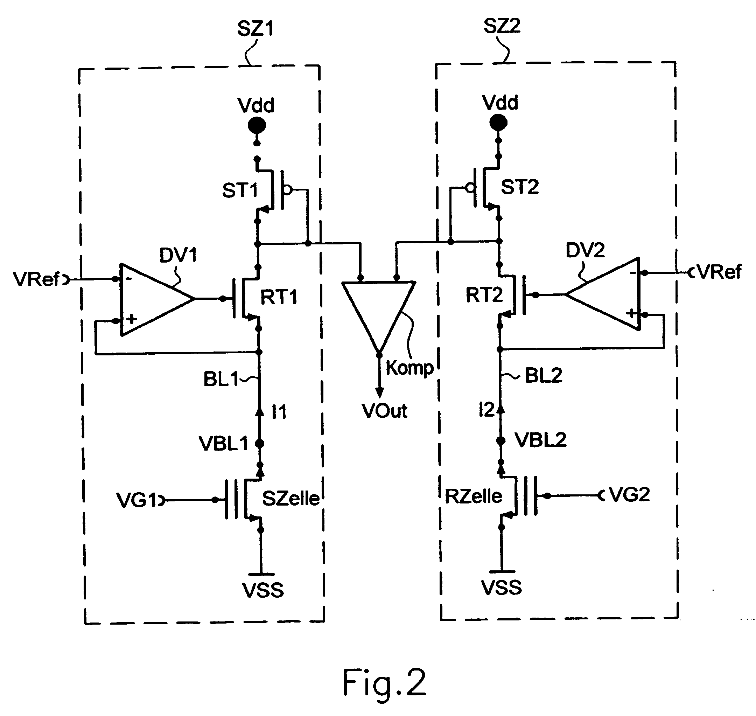

In Fig. 2 ist eine weitere Ausleseschaltung gezeigt, welche einen ähnlichen Aufbau wie die in Fig. 1 gezeigte Ausleseschaltung aufweist. Die Ausleseschaltung aus Fig. 2 unterscheidet sich jedoch in einem wesentlichen Punkt von der in Fig. 1 gezeigten Ausleseschaltung. Anstelle eines Inverters steuert im Schaltungszweig SZ1 ein Differenzverstärker DV1 das Potential der Gateelektrode des Regeltransistors RT1, welcher in der in Fig. 2 gezeigten Ausleseschaltung ein p-Kanal-MOSFET ist. Dazu ist der Ausgang des Differenzverstärkers DV1 an den Gateanschluß des Regeltransistors RT1 angeschlossen. An dem invertierenden Eingang des Differenzverstärkers DV1 liegt eine Referenzspannung VRef an. Der nichtinvertierende Eingang des Differenzverstärkers DV1 ist mit der Bitleitung BL1 verbunden. Dadurch wird die Bitleitungsspannung VBL1 auf den Wert der Referenzspannung VRef geregelt. Der Schaltungszweig SZ2 enthält entsprechend dem Schaltungszweig SZ1 einen Differenzverstärker DV2, welcher zusammen mit dem Regeltransistor RT2 die Bitleitungsspannung VBL2 ebenfalls auf den Wert der Referenzspannung VRef regelt. Diese Ausleseschaltung weist gegenüber der in Fig. 1 gezeigten Ausleseschaltung den Vorteil auf, daß der Sollwert der Bitleitungsspannungen VBL1 und VBL2, welcher durch die Referenzspannung Vref gegeben ist, durch einen externen Schaltkreis generiert werden kann. Durch geeignete Schaltungen, wie z.B. eine Bandabstandsreferenz-Schaltung, kann somit eine wesentlich genauere und temperaturunabhängige Spannung erzeugt werden, als dieses mit einem Inverter möglich ist. Des weiteren wird durch die in Fig. 2 gezeigte Ausleseschaltung die Störempfindlichkeit des Sollwerts der Bitleitungsspannungen VBL1 und VBL2 gegenüber Schwankungen der Versorgungsspannung VDD reduziert.

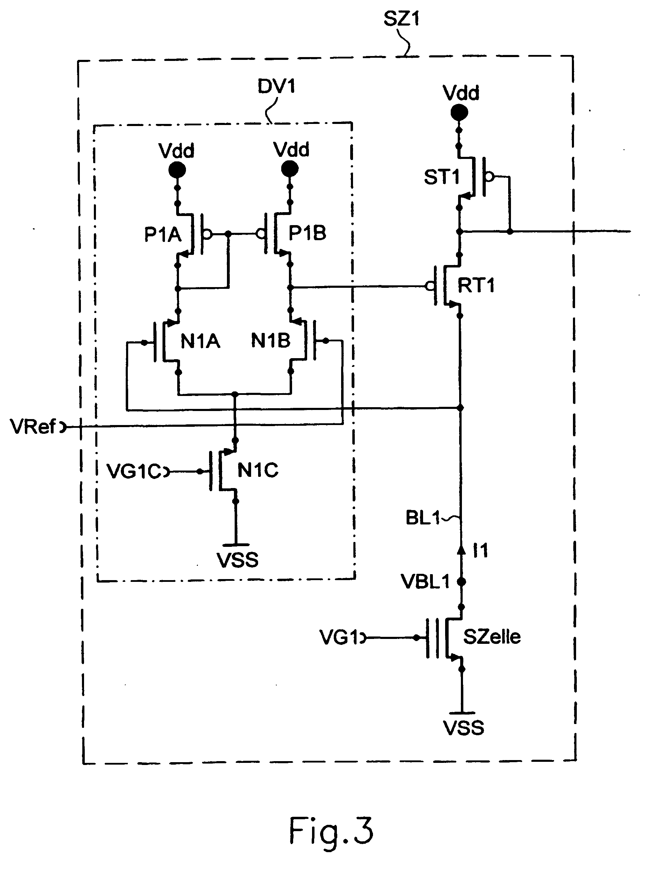

Fig. 3 zeigt ein einfaches Ausführungsbeispiel für den Differenzverstärker DV1 des Schaltungszweigs SZ1. Hierbei handelt es sich um einen CMOS-Differenzverstärker mit einer aus n-Kanal-MOSFETs N1A und N1B aufgebauten Differenzstufe, einer aus p-Kanal-MOSFETs P1A und P1B aufgebauten Stromspiegellast sowie einem als Stromquelle dienenden n-Kanal-MOSFET N1C mit einer steuerbaren Gatespannung VG1C. Weitere Schaltungen für Differenzverstärker sind in der Literatur zu finden.

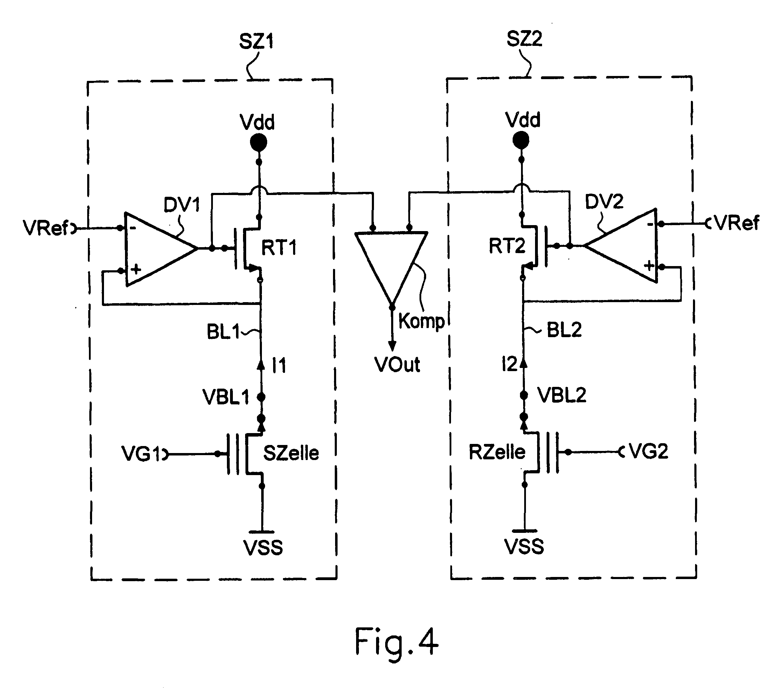

Fig. 4 zeigt ein erstes Ausführungsbeispiel der erfindungsgemäßen Ausleseschaltung. Im wesentlichen entspricht das erste Ausführungsbeispiel der in Fig. 2 gezeigten Ausleseschaltung. Jedoch fehlen hier die Stromspiegeltransistoren ST1 und ST2. Ihre Funktion übernehmen die Regeltransistoren RT1 und RT2. In dem ersten Ausführungsbeispiel speisen die Ausgänge der Differenzverstärker DV1 und DV2 zusätzlich die Eingänge des Komparators Komp.

Aufgrund der eingesparten Stromspiegeltransistoren ST1 und ST2 verringert sich der Spannungsabfall zwischen der Versorgungsspannung VDD und den Bitleitungen BL1 und BL2. Folglich kann die in Fig. 4 gezeigte Ausleseschaltung auch bei einer relativ kleinen Versorgungsspannung VDD betrieben werden.

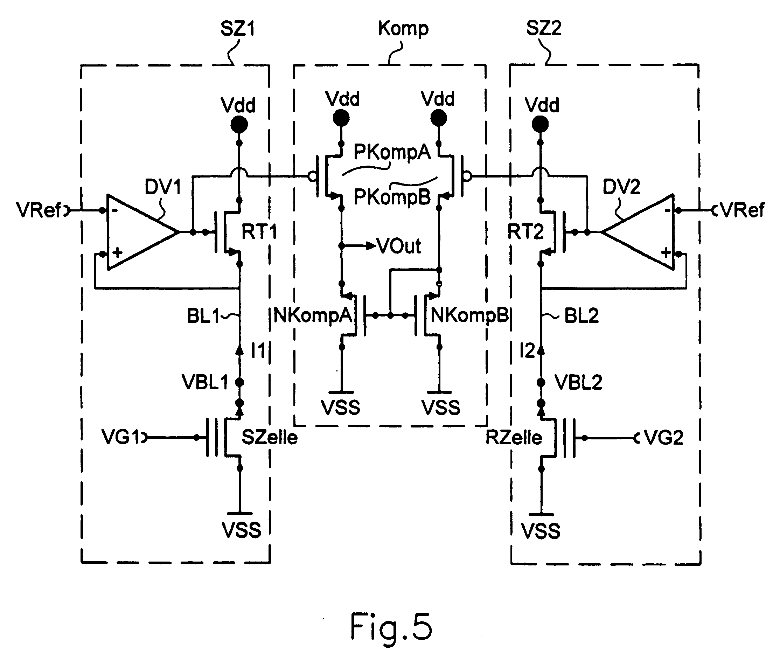

In Fig. 5 ist ein zweites Ausführungsbeispiel der erfindungsgemäßen Ausleseschaltung mit einer möglichen Ausführungsform des Komparators Komp gezeigt. Für den Komparator Komp wird eine einfache Stromkomparatorschaltung bestehend aus zwei p-Kanal-MOSFETs PKompA und PKompB sowie zwei n-Kanal-MOSFETs NKompA und NKompB verwendet. Der Strom I1 der Speicherzelle SZelle wird nach PKompA gespiegelt. Der Strom I2 der Referenzzelle RZelle wird über PKompB und NKompB nach NKompA gespiegelt. Sofern der Strom I1 größer als der Strom I2 ist, liegt das Ausgangssignal VOut des Komparators Komp auf dem Potential der Versorgungsspannung VDD. Im umgekehrten Fall wird das Ausgangssignal VOut zum Potential der Masse VSS gezogen. Da der Ladezustand der Referenzzelle RZelle bekannt ist, kann anhand des Ausgangssignals VOut auf den Ladezustand der Speicherzelle SZelle geschlossen werden.

## Patentansprüche

1. Ausleseschaltung zur Feststellung des Ladezustands einer nichtflüchtigen Speicherzelle (SZelle), wobei
- ein Ladezustandsstrom (I1) der Speicherzelle (SZelle) ein dem Ladezustand der Speicherzelle (SZelle) entsprechendes Signal ist,
- an einen Leseausgang der Speicherzelle (SZelle), durch welchen der Ladezustandsstrom (I1) fließt, ein erster Anschluß der Source-Drain-Strecke eines Regeltransistors (RT1) geschaltet ist,
- der Ausgang eines Differenzverstärkers (DV1) mit dem Gateanschluß des Regeltransistors (RT1) verbunden ist,
- an den ersten Eingang des Differenzverstärkers (DV1) eine vorgegebene Spannung (VRef) angelegt ist,
- der zweite Eingang des Differenzverstärkers (DV1) mit dem Leseausgang der Speicherzelle (SZelle) verbunden ist, und
- die Ausleseschaltung einen Komparator (Komp) aufweist, an dessen erstem Eingang ein dem Ladezustand der Speicherzelle (SZelle) entsprechende Signal anliegt und an dessen zweitem Eingang ein vorgegebener Referenzwert anliegt, wobei aus dem Ausgangssignal (VOut) des Komparators (Komp) der Ladezustand der Speicherzelle (SZelle) ermittelbar ist,
**dadurch gekennzeichnet,**
- **daß** an den zweiten Anschluß der Source-Drain-Strecke des Regeltransistors (RT1) eine Versorgungsspannung (VDD) angelegt ist, und
- **daß** der Ausgang des Differenzverstärkers (DV1) mit dem ersten Eingang des Komparators (Komp) verbunden ist.

2. Ausleseschaltung nach Anspruch 1,
**dadurch gekennzeichnet,**
- **daß** der Regeltransistor (RT1) ein p-Kanal-MOSFET ist, dessen Drainanschluß an dem Leseausgang anliegt.

3. Ausleseschaltung nach Anspruch 1 oder 2,
**dadurch gekennzeichnet,**
- **daß** eine die vorgegebene Spannung (VRef) erzeugende Bandabstandsreferenz-Schaltung mit dem ersten Eingang des Differenzverstärkers (DV1) verbunden ist.

4. Ausleseschaltung nach einem oder mehreren der vorhergehenden Ansprüche,
**dadurch gekennzeichnet,**
- **daß** der vorgegebene Referenzwert ein dem Ladezustand einer Referenzzelle (RZelle) entsprechendes Signal ist, wobei
- der Ladezustand der Referenzzelle (RZelle) vorgegeben ist, und
- das dem Ladezustand der Referenzzelle (RZelle) entsprechende Signal mit einer Schaltung zum Auslesen eines Ladezustandsstroms (I2) aus der nichtflüchtigen Referenzzelle (RZelle) ermittelbar ist, wobei
- der Ladezustandsstrom (I2) ein dem Ladezustand der Referenzzelle (RZelle) entsprechendes Signal ist,
- an einen Leseausgang der Referenzzelle (RZelle), durch welchen der Ladezustandsstrom (I2) fließt, ein erster Anschluß der Source-Drain-Strecke eines weiteren Regeltransistors (RT2) geschaltet ist,
- an den zweiten Anschluß der Source-Drain-Strecke des weiteren Regeltransistors (RT2) die Versorgungsspannung (VDD) angelegt ist,
- der Ausgang eines weiteren Differenzverstärkers (DV2) mit dem Gateanschluß des weiteren Regeltransistors (RT2) verbunden ist,
- an den ersten Eingang des weiteren Differenzverstärkers (DV2) eine weitere vorgegebene Spannung (VRef) angelegt ist,
- der zweite Eingang des weiteren Differenzverstärkers (DV2) mit dem Leseausgang der Referenzzelle (RZelle) verbunden ist, und
- der Ausgang des weiteren Differenzverstärkers (DV2) mit dem zweiten Eingang des Komparators (Komp) verbunden ist.

5. Ausleseschaltung nach Anspruch 4,
**dadurch gekennzeichnet,**
- **daß** die vorgegebene Spannung (VRef) zum Auslesen des Ladezustandsstroms (I1) der Speicherzelle (SZelle) gleich der weiteren vorgegebenen Spannung (VRef) zum Auslesen des Ladezustandsstroms (I2) der Referenzzelle (RZelle) ist.

6. Speichervorrichtung mit einer madrixförmigen Anordnung aus nichtflüchtigen Speicherzellen (SZelle), welche durch Schaltmittel mit einer Ausleseschaltung nach einem oder mehreren der vorhergehenden Ansprüche verbunden sind.

7. EEPROM-, EAROM- oder Flash-EPROM-Speicherbausteine mit einer Mehrzahl nichtflüchtiger Speicherzellen (SZelle), welche durch Schaltmittel mit einer Ausleseschaltung nach einem oder mehreren der Ansprüche 1 bis 5 verbunden sind.

## Claims

1. Read circuit for determining the charge state of a non-volatile memory cell (SZelle),
- a charge state current (I1) of the memory cell (SZelle) being a signal which corresponds to the charge state of the memory cell (SZelle),
- a first connection of the source/drain path in a control transistor (RT1) being connected to a read output of the memory cell (SZelle), through which output the charge state current (I1) flows,
- the output of a differential amplifier (DV1) being connected to the gate connection of the control transistor (RT1),
- a prescribed voltage (VRef) being applied to the first input of the differential amplifier (DV1),
- the second input of the differential amplifier (DV1) being connected to the read output of the memory cell (SZelle), and
- the read circuit having a comparator (Komp), to whose first input a signal corresponding to the charge state of the memory cell (SZelle) is applied and to whose second input a prescribed reference value is applied, with it being possible to use the output signal (VOut) from the comparator (Komp) to ascertain the charge state of the memory cell (SZelle),
**characterized**
- **in that** a supply voltage (VDD) is applied to the second connection of the source/drain path in the control transistor (RT1), and
- **in that** the output of the differential amplifier (DV1) is connected to the first input of the comparator (Komp).

2. Read circuit according to Claim 1,
**characterized**
- **in that** the control transistor (RT1) is a p-channel MOSFET whose drain connection is connected to the read output.

3. Read circuit according to Claim 1 or 2,
**characterized**
- **in that** a bandgap reference circuit which produces the prescribed voltage (VRef) is connected to the first input of the differential amplifier (DV1).

4. Read circuit according to one or more of the preceding claims,
**characterized**
- **in that** the prescribed reference value is a signal which corresponds to the charge state of a reference cell (RZelle),
- the charge state of the reference cell (RZelle) being prescribed, and
- a circuit for reading a charge state current (I2) from the non-volatile reference cell (RZelle) being able to be used to ascertain the signal which corresponds to the charge state of the reference cell (RZelle),
- the charge state current (I2) being a signal which corresponds to the charge state of the reference cell (RZelle),
- a first connection of the source/drain path in a further control transistor (RT2) being connected to a read output of the reference cell (RZelle), through which output the charge state current (I2) flows,
- the supply voltage (VDD) being applied to the second connection of the source/drain path in the further control transistor (RT2),
- the output of a further differential amplifier (DV2) being connected to the gate connection of the further control transistor (RT2),
- a further prescribed voltage (VRef) being applied to the first input of the further differential amplifier (DV2),
- the second input of the further differential amplifier (DV2) being connected to the read output of the reference cell (RZelle), and
- the output of the further differential amplifier (DV2) being connected to the second input of the comparator (Komp).

5. Read circuit according to Claim 4,
**characterized**
- **in that** the prescribed voltage (VRef) for reading the charge state current (11) of the memory cell (SZelle) is equal to the further prescribed voltage (VRef) for reading the charge state current (I2) of the reference cell (RZelle).

6. Memory apparatus having a matrix-like arrangement of non-volatile memory cells (SZelle) which are connected to a read circuit according to one or more of the preceding claims using switching means.

7. EEPROM, EAROM or flash EPROM memory chips having a plurality of non-volatile memory cells (SZelle) which are connected to a read circuit according to one or more of Claims 1 to 5 using switching means.

## Revendications

1. Circuit de lecture pour constater l'état de charge d'une cellule de mémoire non volatile (cellule S) dans lequel
- un courant (I1) d'état de charge de la cellule (cellule S) de mémoire est un signal correspond à l'état de charge de la cellule (cellule S) de mémoire,
- à une sortie de lecture de la cellule (cellule S) de mémoire, dans laquelle passe le courant (I1) d'état de charge, est reliée une première borne de la section de source-drain d'un transistor (RT1) de régulation,
- la sortie d'un amplificateur (DV1) différentiel est reliée à la borne de grille du transistor (RT1) de régulation,
- une tension (VRef) prescrite est appliquée à la première entrée de l'amplificateur (DV1) différentiel,
- la deuxième entrée de l'amplificateur (DV1) différentiel est reliée à la sortie de lecture de la cellule (cellule S) de mémoire, et
- le circuit de lecture a un comparateur (Komp) à la première entrée duquel est appliqué un signal correspondant à l'état de charge de la cellule (cellule S) de mémoire et à la deuxième entrée duquel est appliquée une valeur de référence prescrite, l'état de charge de la cellule (cellule S) de mémoire pouvant être déterminé à partir du signal (VOut) de sortie du comparateur (Komp),
**caractérisé**
- **en ce qu'**il est appliqué à la deuxième borne de la section de source-drain du transistor (RT1) de régulation une tension (VDD) d'alimentation, et
- **en ce que** la sortie de l'amplificateur (DV1) différentiel est reliée à la première entrée du comparateur (Komp).

2. Circuit de lecture suivant la revendication 1,
**caractérisé**
- **en ce que** le transistor (RT1) de régulation est un MOSFET à canal p dont la borne de drain est reliée à la sortie de lecture.

3. Circuit de lecture suivant la revendication 1 ou 2,
**caractérisé**
- **en ce qu'**un circuit de référence à intervalle d'énergie entre deux bandes produisant la tension (VRef) prescrite est relié à la première entrée de l'amplificateur (DV1) différentiel.

4. Circuit de lecture suivant l'une ou plusieurs des revendications précédentes,
**caractérisé**
- **en ce que** la valeur de référence prescrite est un signal correspondant à l'état de charge d'une cellule (cellule R) de référence, dans lequel
- l'état de charge de la cellule (cellule R) de référence est prescrit et
- le signal correspondant à l'état de charge de la cellule (cellule R) de référence peut être déterminé par un circuit de lecture d'un courant (I2) d'état de charge dans la cellule (cellule R) de référence non volatile, dans lequel
- le courant (I2) d'état de charge est un signal correspondant à l'état de charge de la cellule (cellule R) de référence,
- une première borne de réception de source-drain d'un autre transistor (RT2) de régulation est reliée à une sortie de lecture de la cellule (cellule R) de référence par laquelle passe le courant (I2) d'état de charge,
- la tension (VDD) d'alimentation est appliquée à la deuxième borne de la section de source-drain de l'autre transistor (RT2) de régulation,
- la sortie d'un autre amplificateur (DV2) différentiel est reliée à la borne de grille de l'autre transistor (RT2) de régulation,
- une autre tension (VRef) prescrite est appliquée à la première entrée de l'autre amplificateur (DV2) différentiel,
- la deuxième entrée de l'autre amplificateur (DV2) différentiel est reliée à la sortie de lecture de la cellule (cellule R) de référence, et
- la sortie de l'autre amplificateur (DV2) différentiel est reliée à la deuxième entrée du comparateur (Komp).

5. Circuit de lecture suivant la revendication 4,
**caractérisé**
- **en ce que** la tension (VRef) prescrite de lecture du courant (I1) d'état de charge de la cellule (cellule S) de mémoire est égale à l'autre tension (VRef) prescrite de lecture du courant (I2) d'état de charge de la cellule (cellule R) de référence.

6. Dispositif de mémoire ayant une disposition en forme de matrice de cellules (cellule S) de mémoire non volatiles qui sont reliées par des moyens de commutation à un circuit de lecture suivant l'une ou plusieurs des revendications précédentes.

7. Module d'EEPROM, d'EAROM ou d'EPROM Flash ayant une multiplicité de cellules (cellule S) de mémoire non volatiles qui sont reliées par des moyens de commutation à un circuit de lecture suivant une ou plusieurs des revendications 1 à 5.
